# EUROPEAN PATENT SPECIFICATION

(11) **EP 0 712 152 B1**
(45) Date of publication and mention of the grant of the patent: **29.08.2001**
(21) Application number: 95307956.3
(22) Date of filing: 07.11.1995
(51) Int. Cl.: H01L 21/266, H01L 21/8238

(54) **Method of manufacturing a semiconductor device**
Verfahren zur Herstellung einer Halbleiteranordnung
Procédé de fabrication d'un dispositif à semi-conducteur

(30) Priority: 10.11.1994 JP 27619594
(43) Date of publication of application: 15.05.1996
(73) Proprietor: FUJI ELECTRIC CO. LTD., Kawasaki 210 (JP)
(72) Inventor: Fujihira, Tatsuhiko, Kawasaki-ku, Kawasaki 210 (JP); Nishimura, Takeyoshi, Kawasaki-ku, Kawasaki 210 (JP); Momota, Seiji, Kawasaki-ku, Kawasaki 210 (JP)
(74) Representative: Bridge-Butler, Alan James

(56) References cited:
- EP-A- 0 294 868
- US-A- 3 933 528
- US-A- 5 053 838
- PATENT ABSTRACTS OF JAPAN vol. 005 no. 078 (E-058) ,22 May 1981 & JP-A-56 027933 (MATSUSHITA ELECTRIC IND CO LTD) 18 March 1981,

## Description

The present invention relates to semiconductor devices such as insulated gate type devices, ICs, power ICs, etc. and a method of manufacturing such semiconductor devices.

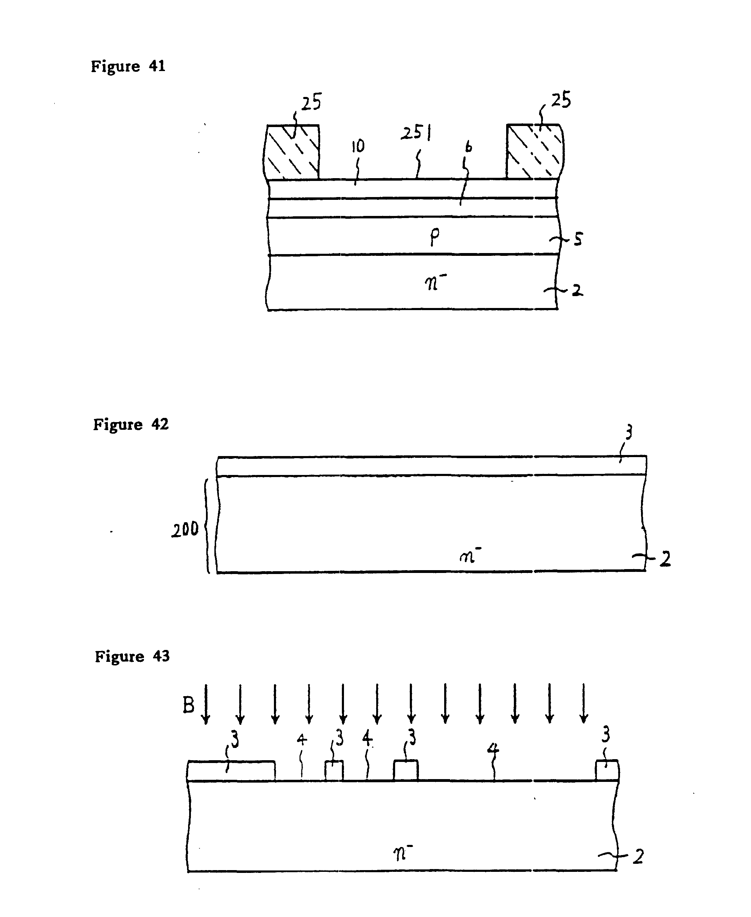

Various techniques are known for the design of semiconductor devices and for manufacturing the semiconductor devices. For example, US Patent 5,053,838 discloses a power IC and a method for its manufacture. US Patents 4,959,699 and 5,008,725 disclose vertical MOSFETs and methods for their manufacture. US Patents 4,364,073 and 5,034,336 disclose vertical IGBTs and methods for their manufacture. US Patents 5,191,396 and 5,162,883 respectively disclose a lateral MOSFET and a lateral IGBT and methods for their manufacture. As a typical example of the prior art, the structure of an IC portion of the power IC disclosed in US Patent 5,053,838, and its manufacturing method, are shown in Figures 42 to 48.

STEP(1): Referring now to Figure 42, a first insulation film 3 of about 1000nm in thickness is formed by thermally oxidising an n-type semiconductor layer 2, doped with phosphorus at around 1x10¹⁶cm⁻³, in steam at 1100°C for 3 hours.

STEP(2): Referring now to Figure 43, windows 4 are formed by selectively etching the predetermined parts of the first insulation film 3 by hydrofluoric acid etc., using a photoresist film patterned by photolithography for masking.

STEP(3): Then, boron ions are implanted at a dose amount of 2x10¹³cm⁻² in the surface layer of the n-type semiconductor layer 2 through the windows 4, at an acceleration voltage of 100keV.

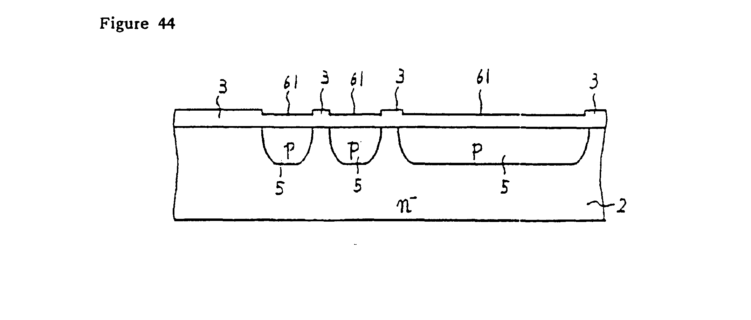

STEP(4): Referring now to Figure 44, the boron ions are diffused by heat treatment at 1100°C for 3 hours to form p-type regions 5 in the surface layer of the n-type semiconductor layer 2.

STEP(5): Subsequently, steam oxidation is conducted at 1100°C for 80 minutes to form second insulation films 61 of thermally oxidised silicon of about 650nm in thickness. These second insulation films 61, used for inter-layer insulation of wiring in the ICs or for field plates of the power devices, need not be formed to precisely this thickness, provided that they are effective as insulation films.

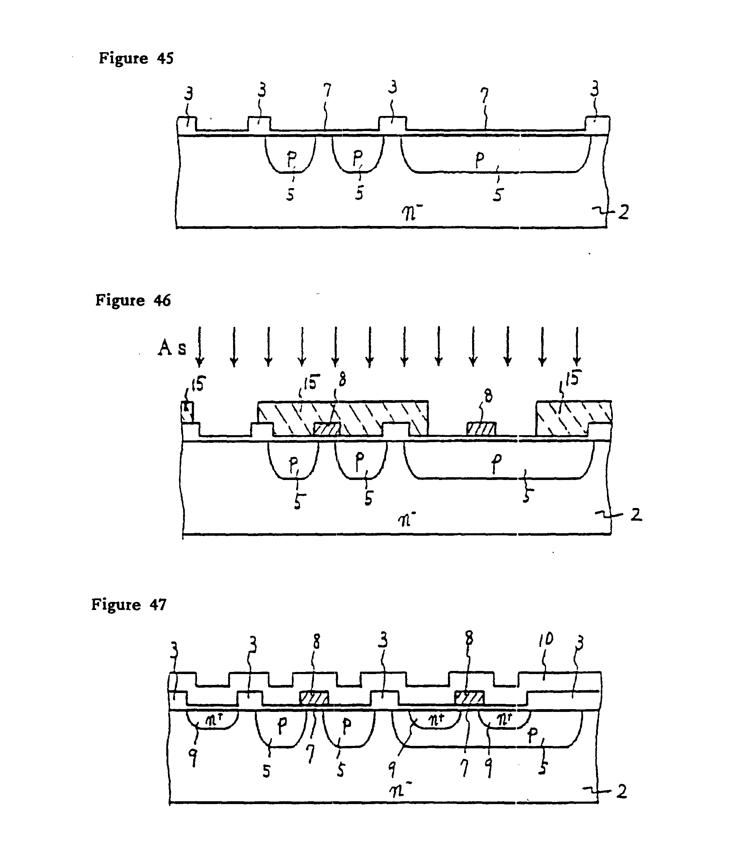

STEP(6): As shown in Figure 45, the predetermined parts of the first and second insulation films are simultaneously etched away, with for example hydrofluoric acid, using a photoresist film patterned by photolithography for masking.

STEP(7): Then, third insulation films 7 of oxide of about 50nm in thickness are formed, for example, by dry oxidation at 1000°C for 30 minutes.

STEP(8): Referring now to Figure 46, a poly-crystalline silicon film is deposited to a thickness of 500nm by CVD. Phosphorus ions are implanted at an acceleration voltage of 100keV into the poly-crystalline silicon film at a dose amount of 5x10¹⁵cm⁻². The implanted phosphorus ions are activated by heat treatment at 1000°C for 10 minutes, and gate electrodes 8 are formed by selectively etching the poly-crystalline silicon film by using a photoresist film patterned by photolithography for masking.

STEP(9): Then, heavily doped n-type regions 9 are formed in the surface layers of the n-type substrate 2 and a p-type region by implanting arsenic ions at a dose amount of 5x10¹⁵cm⁻² and an acceleration voltage of 150keV, using a photoresist film 15 patterned by photolithography to mask the first insulation films 3 and the gate electrodes 8.

STEP(10): Referring now to Figure 47, a fourth insulation film 10 of BPSG film of about 1000nm in thickness is formed by CVD techniques or other suitable methods.

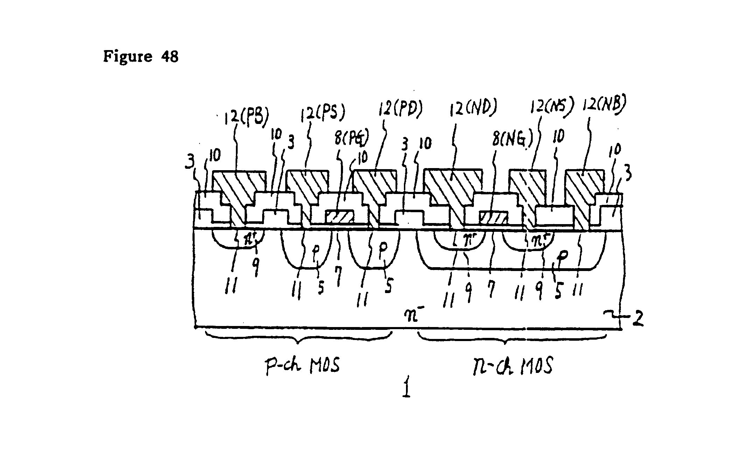

STEP(11): Referring now to Figure 48, contact holes 11, which reach the p-type regions 5 and the heavily doped n-type regions 9 through the fourth insulation film 10, are formed by selectively etching the BPSG film by using a photoresist film patterned by photolithography for masking.

STEP(12): Finally, metal electrodes 12 are formed by depositing an Aluminium-Silicon-Copper film with a thickness of about 1000nm by sputtering etc., and then selectively etching the film using a photoresist film patterned by photolithography for masking.

The semiconductor device 1 produced by this method comprises a p-channel MOSFET having a back gate electrode 12(PB), a source electrode 12(PS), a gate electrode 8(PG), and a drain electrode 12(PD); and an n-channel MOSFET having a back gate electrode 12(NB), a source electrode 12(NS), a gate electrode 8(NG), and a drain electrode 12(ND). This device structure facilitates the production of CMOS integrated circuits (ICs).

The manufacturing method described above includes ten photo-processing steps. To reduce the manufacturing cost of these semiconductor devices, it is necessary to reduce the number of photo-processing steps.

In view of the foregoing, it is an object of the invention to provide a semiconductor device that has the same structure and exhibits the same performance as those of the conventionally produced devices, and to provide a method of manufacturing the semiconductor device that eliminates one step from the conventional photo-processing steps and thus facilitates reducing the cost of the semiconductor device.

According to the present invention, there is provided a method of manufacturing at least one semiconductor device on a single- or multi-layered semiconductor substrate, the method comprising the steps of:
forming a first insulation film on a major surface of a layer of a first conductivity type of the semiconductor substrate;
selectively removing a part of the first insulation film, thereby to form at least one window in the first insulation film;
implanting impurity ions of a second conductivity type into the layer of the first conductivity type through the at least one window;
selectively forming at least one region of the second conductivity type by thermally diffusing the implanted impurity ions into the layer of the first conductivity type;
forming a second insulation film prior to or after the formation of the at least one region of the second conductivity type;
selectively removing a part of the first and second insulation films thereby to expose a part of the layer of the first conductivity type and a part of the at least one region of the second conductivity type;
forming third insulation films on the exposed part of the layer of the first conductivity type and the exposed part of the at least one region of the second conductivity type;
forming gate electrodes on the third insulation films;
forming heavily doped regions of the first conductivity
forming heavily doped regions of the first conductivity type by selectively implanting impurity ions of the first conductivity type, using said first insulation film said second insulation film and said gate electrodes for masking, into the portions of said layer of the first conductivity type and said at least one region of the second conductivity type, said portions being not covered with said first insulation film (3) said second insulation film and said gate electrodes;
forming a fourth insulation film on top of the at least one semiconductor device;
and simultaneously forming at least one contact hole that reaches the at least one region of the second conductivity type through the fourth and second insulation films, and at least one contact hole that reaches the heavily doped regions of the first conductivity type through the fourth insulation film, characterised in that said second insulation film (6) is more than twice as thick as the average implantation depth of said impurity ions of the first conductivity type in the insulation film.

It is preferable that the second insulation film is less than ten times as thick as the average implantation depth of the impurity ions of the first conductivity type in the insulation film. When a plurality of the semiconductor devices are to be arranged on a semiconductor substrate, it is quite effective to dispose at least one monitor region for judging the end of etching for removing the fourth and second insulation films at the formation of the contact holes on at least one of the at least one region of the second conductivity type, this region being formed on a portion of the semiconductor substrate away from the plurality of the semiconductor devices, the at least one monitor region comprising a second insulation film and a fourth insulation film laminated on the at least one of the at least one region of the second conductivity type, and to terminate the etching after the second and fourth insulation films have been removed and the at least one of the at least one region has been exposed.

Preferably, the at least one monitor region is arranged outside the region of the semiconductor substrate on which the plurality of semiconductor devices are arranged. More specifically, the at least one monitor region is surrounded by a plurality of the semiconductor devices. Alternatively, the at least one monitor region is arranged on at least one of the scribe lines disposed for separating the semiconductor devices from one another. As a further alternative, the at least one monitor region may be arranged in a peripheral region of the semiconductor substrate away from the plurality of the semiconductor devices. Alternatively, monitor regions may be arranged in both of the locations described above. The etching of the fourth and second insulation films may be terminated after a predetermined period of time has elapsed, the predetermined period consisting of a leeway period and an estimated period, the estimated period being a determined or calculated period of time during which the fourth and second insulation films are completely removed.

In the at least one of the semiconductor device manufactured by the method of the present invention, the thickness of the insulation film varies around each of the contact holes, between the contact holes, or around and between the contact holes. The semiconductor device or devices of the invention may include at least one device selected from a group consisting of an insulated gate type device, an IC and power IC. The semiconductor device or devices of the invention may include at least one of the devices selected from a group consisting of a vertical MOSFET, a vertical IGBT, a lateral MOSFET and a lateral IGBT.

By setting the thickness of the second insulation film to be two or more times the average implantation depth (i.e. the depth at which the dose amount of the implanted impurity ions shows a maximum) of the impurity ions of the first conductivity type (e.g. arsenic), the second insulation film is able to function as a mask for arsenic ion implantation for forming the at least one heavily doped n-type region. The required thickness of the second insulation film is from around 100nm (the minimum thickness for masking the ion implantation) to around 500nm (due to mass production economy considerations). Since the required thickness of the second insulation film is less than the conventional thickness, the thickness of the second insulation film must be controlled more accurately. Moreover, it is preferable to form the second insulation film after the formation of the at least one region of the second conductivity type. Since the lattice defects caused in the region or regions of the second conductivity type by the implantation of the impurity ions (boron ions etc.) of the second conductivity type are reduced by annealing conducted at the formation of the region or regions of the second conductivity type, the oxide film deposited on the annealed region or regions of the second conductivity type exhibits an excellent film quality. By using the second insulation film for masking the implantation of the impurity ions of the first conductivity type, the conventional processing step of depositing a masking photoresist film becomes unnecessary and one photo-processing step is eliminated.

For forming the contact holes, the second and fourth insulation films should be removed from above the at least one region of the second conductivity type and the fourth insulation film from above each of the heavily doped n-type regions. Since these insulation films are formed of an oxide film, the thickness thereof for the fourth insulation film is around 100nm and the thickness thereof for the second insulation film is 100 to 500nm, the film laminate of the fourth and second insulation films should completely be removed from above the at least one region of the second conductivity type. In order to secure the complete removal of the film laminate, at least one monitor region is provided. The monitor region is preferably arranged outside that area of the semiconductor substrate in which semiconductor device or devices are arranged. The monitor region has a region of the second conductivity type on which are laminated a second insulation film and a fourth insulation film.

When the monitor region may occupy a relatively narrow area, it is preferable to surround the monitor region by a plurality of the semiconductor devices for facilitating detection of the end of the etching step in a plasma-etching apparatus. When the monitor region requires a relatively wide area, it is preferable to dispose the monitor region on a scribe line or in the peripheral region of the semiconductor wafer for facilitating monitoring. A plurality of monitor regions may be disposed in a combined fashion on the locations described above. Alternatively or additionally, the etching of the fourth and second insulation films may be terminated after a predetermined period of time has elapsed, the predetermined period consisting of a leeway period and an estimated period, the estimated period being a determined or calculated period of time during which the fourth and second insulation films are completely removed. The predetermined period of time is determined by considering the variation of the etching environments etc.

The present invention will be explained in detail with reference to the accompanying drawings, which illustrate preferred embodiments of the invention. Parts similar to those of the embodiments of Figures 42 to 48 are designated by the same reference numerals. The invention will be explained by way of example in that a first conductivity type is n-type and a second conductivity type is p-type, it being understood that the process can be applied with n-type as the first conductivity type and p-type as the second conductivity type. In the Figures:
Figure 1 is a sectional view showing STEP(1) of a first embodiment of a method of manufacturing a power IC;
Figure 2 is a sectional view showing STEP(2) and STEP(3) of the first method;
Figure 3 is a sectional view showing STEP(4) and STEP(5) of the first method;
Figure 4 is a sectional view showing STEP(6) and STEP(7) of the first method;
Figure 5 is a sectional view showing STEP(8) and STEP(9) of the first method;
Figure 6 is a sectional view showing STEP(10) of the first method;
Figure 7 is a sectional view showing STEP(11) and STEP(12) of the first method as well as showing the major part of the semiconductor device manufactured by the method;
Figure 8 is a sectional view showing STEP(1) of a second embodiment of a method of manufacturing a power IC;
Figure 9 is a sectional view showing STEP(2) and STEP(3) of the second method;
Figure 10 is a sectional view showing STEP(4) and STEP(5) of the second method;
Figure 11 is a sectional view showing STEP(6) and STEP(7) of the second method;
Figure 12 is a sectional view showing STEP(8) and STEP(9) of the second method;
Figure 13 is a sectional view showing STEP(10) of the second method;
Figure 14 is a sectional view showing STEP(11), STEP(12) and STEP(13) of the second method as well as showing the major part of the semiconductor device manufactured by the second method;
Figure 15 is a sectional view showing STEP(1) of a third embodiment of a method of manufacturing a power IC according to the present invention;
Figure 16 is a sectional view showing STEP(2) and STEP(3) of the third method;
Figure 17 is a sectional view showing STEP(4) and STEP(5) of the third method;
Figure 18 is a sectional view showing STEP(6) and STEP(7) of the third method;
Figure 19 is a sectional view showing STEP(8) and STEP(8.1) of the third method;
Figure 20 is a sectional view showing STEP(9) of the third method;
Figure 21 is a sectional view showing STEP(10) of the third method;
Figure 22 is a sectional view showing STEP(11), STEP(12) and STEP(13) of the third method as well as showing the major part of the semiconductor device manufactured by the third method;
Figure 23 is a sectional view showing STEP(1) of a fourth embodiment of a method of manufacturing a power IC according to the present invention;
Figure 24 is a sectional view showing STEP(2) and STEP(3) of the fourth method;
Figure 25 is a sectional view showing STEP(4) and STEP(5) of the fourth method;
Figure 26 is a sectional view showing STEP(6) and STEP(7) of the fourth method;
Figure 27 is a sectional view showing STEP(8) and STEP(8.1) of the fourth method;
Figure 28 is a sectional view showing STEP(9) of the fourth method;
Figure 29 is a sectional view showing STEP(10) of the fourth method;
Figure 30 is a sectional view showing STEP(11) and STEP(12) of the fourth method as well as showing the major part of the semiconductor device manufactured by the fourth method;
Figure 31(a) is a sectional view showing steps (1.1) to (1.5) of a fifth embodiment of a manufacturing method according to the present invention;
Figure 31(b) is a cross section of the major part of the semiconductor device manufactured by the fifth method of the present invention;
Figure 32(a) is a sectional view showing STEP (1) of a sixth embodiment of a manufacturing method according to the present invention;
Figure 32(b) is a cross section of the major part of the semiconductor device manufactured by the sixth method of the present invention;
Figure 33(a) is a sectional view showing STEP (1) of a seventh embodiment of a manufacturing method according to the present invention;
Figure 33(b) is a cross section of the major part of the semiconductor device manufactured by the seventh method of the present invention;
Figure 34 is a sectional view showing STEP(4) and STEP(5) of a eighth embodiment of a manufacturing method according to the present invention;
Figure 35 is a sectional view showing STEP(6) and STEP(7) of the eighth method;
Figure 36 is a sectional view showing STEP(8) and STEP(8.1) of the eighth method;
Figure 37 is a sectional view showing STEP(9) of the eighth method;
Figure 38 is a sectional view showing STEP(10) of the eighth method;
Figure 39 is a sectional view showing STEP(11) and STEP(12) of the eighth method as well as showing the major part of the semiconductor device manufactured by the eighth method;
Figure 40(a) is a top plan view of a semiconductor wafer showing a monitor region located on the semiconductor wafer;
Figure 40(b) is an enlarged view of the area A of Figure 40(a), showing scribe lines on the semiconductor wafer;
Figure 41 is a cross section of the monitor region of Figure 40(a);
Figure 42 is a sectional view showing STEP(1) of the prior art;
Figure 43 is a sectional view showing STEP(2) and STEP(3) of the prior art;
Figure 44 is a sectional view showing STEP(4) and STEP(5) of the prior art;
Figure 45 is a sectional view showing STEP(6) and STEP(7) of the prior art;
Figure 46 is a sectional view showing STEP(8) and STEP(9) of the prior art;
Figure 47 is a sectional view showing STEP(10) of the prior art, and;
Figure 48 is a sectional view showing STEP(11) and STEP(12) of the prior art as well as showing the major part of the semiconductor device manufactured by the prior art method.

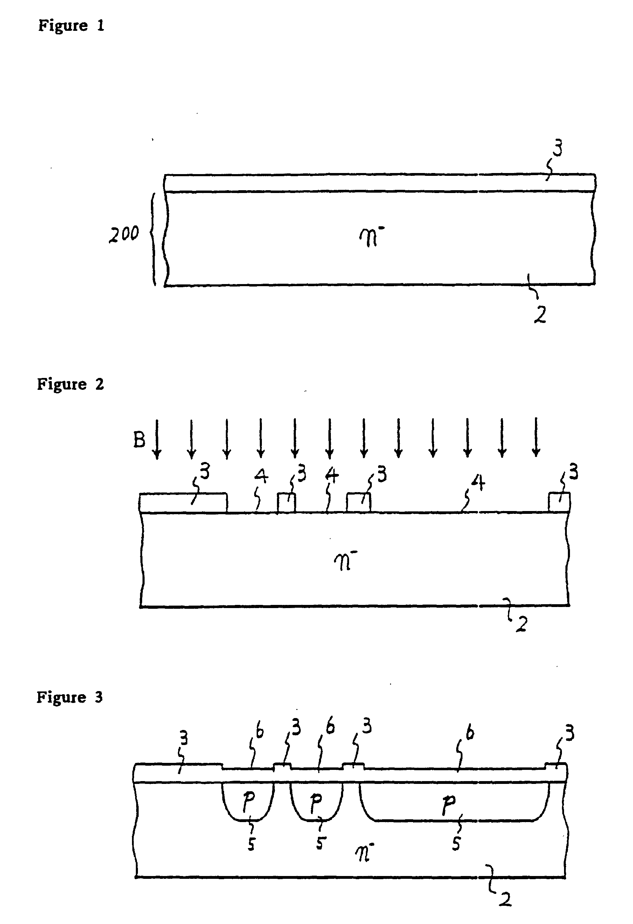

A first embodiment of a manufacturing method of the invention will be explained with reference to FIGS 1 to 7. The first embodiment is an example in that the present invention is applied to the IC portion of the power IC of Figures 42 to 48. The present manufacturing method will be explained in the order of its processing steps, as follows:

STEP(1): Referring now to Figure 1, a first insulation film 3 of about 1000nm in thickness is formed by thermally oxidising an n-type semiconductor layer 2, doped with phosphorus at around 1x10¹⁶cm⁻³, in steam at 1100°C for 3 hours. Hereinafter, a semiconductor substrate on which the n-type semiconductor layer 2 has been formed will be referred to as a "semiconductor wafer".

STEP(2): Referring now to Figure 2, windows 4 are formed by selectively etching away predetermined parts of the first insulation film 3 with, for example, hydrofluoric acid, using a photoresist film patterned by photolithography for masking areas not to be etched.

STEP(3): Boron ions B are selectively implanted at a dosage amount of 2x10¹³cm⁻² in the surface layer of the n-type semiconductor layer 2 through the windows 4, at the acceleration voltage of 100keV.

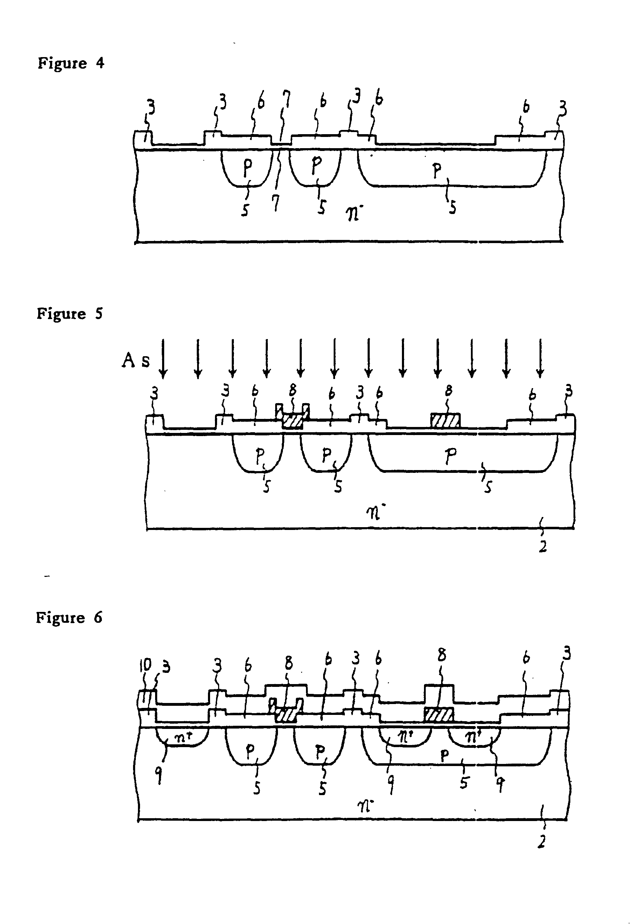

STEP(4): Referring now to Figure 3, the boron ions are diffused by heat treatment at 1100°C for 3 hours to form p-type regions 5 in the surface layer of the n-type semiconductor layer 2.

STEP(5): Subsequently to this, second insulation films 6 are formed to a thickness great enough to prevent arsenic ions from penetrating through the second insulation films 6 when they are implanted. The second insulation films 6 are formed by steam oxidation at 1100°C for 20 minutes, thereby to thermally oxidize silicon to form the oxide films of about 300nm in thickness (that is six times as thick as the average depth of implantation of arsenic ions into the oxide films). The minimum thickness of the second insulation films is about 100nm, the minimum thickness through which arsenic ions never penetrate and twice as thick as the average implantation depth of arsenic ions. The maximum thickness of the second insulation films is about 500nm, five times as thick as the average implantation depth of arsenic ions, due to mass production economy considerations. Therefore, the desirable thickness of the second insulation films is from 200 to 350nm. In this processing step, it is important to control the thickness of the second insulation films more accurately than is the case in the prior art methods. The second insulation films may be formed prior to the STEP(4). However, it is preferable to form the second insulation films after completing STEP(4), since any lattice defects caused in the silicon surface layer by boron ion implantation are annealed out in the STEP(4).

STEP(6): Referring now to Figure 4, the predetermined parts of the first and second insulation films are simultaneously etched away, for example using hydrofluoric acid, using a photoresist film patterned by photolithography for masking areas not to be etched. Here, it is important to leave the second insulation films 6 above the p-type regions 5 except for those portions thereof in which the heavily doped n-type regions are to be subsequently formed by arsenic ion implantation.

STEP(7): Then, third insulation films 7 (as gate oxide films) of oxide of about 50nm in thickness are formed, for example, by dry oxidation at 1000°C for 30 minutes.

STEP(8): Referring now to Figure 5, a poly-crystalline silicon film is deposited to a thickness of 500nm by CVD. Phosphorus ions are implanted at the acceleration voltage of 100keV to the poly-crystalline silicon film at the dose amount of 5x10¹⁵cm⁻². The implanted phosphorus ions are activated by heat treatment at 1000°C for 10 minutes. Gate electrodes 8 are formed by selectively etching the poly-crystalline silicon film using a photoresist film patterned by photolithography for masking.

STEP(9): Then, heavily doped n-type regions 9 are formed in the surface layers of the n-type substrate 2 and a p-type region 5 by selectively implanting arsenic ions at a dosage amount of 5x10¹⁵cm⁻² at an acceleration voltage of 150keV, using the first and second insulation films 3 and 6, and the gate electrodes 8, for masking without employing any photolithography.

STEP(10): Referring now to Figure 6, a fourth insulation film 10 of BPSG film of about 1000nm in thickness is formed by CVD or like techniques.

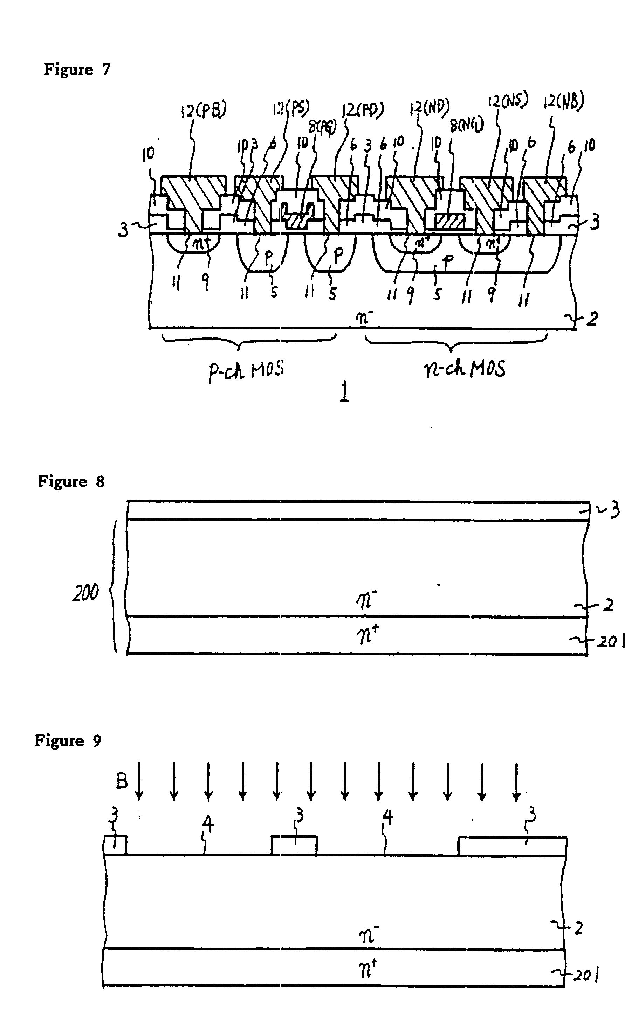

STEP(11): Referring now to Figure 7, contact holes 11, which reach the p-type regions 5 through the fourth insulation film 10 and the second insulation films 6, and contact holes 11, which reach the heavily doped n-type regions 9 through the fourth insulation film, are simultaneously formed by selectively etching the BPSG film by using a photoresist film patterned by photolithography for masking areas not to be etched.

STEP(12): Finally, metal electrodes 12 are formed by selectively depositing an Al-Si-Cu film to a thickness of about 1000nm by sputtering or like methods, and etching using a photoresist film patterned by photolithography for masking areas to be protected.

The specific feature of the above described process for manufacture and its differences from the conventional process for manufacture will be explained below.

In the STEP(5), the second insulation films are formed to a thickness as thin as possible but still thick enough to prevent the arsenic ions, implanted for forming the heavily doped n-type region, from penetrating through the second insulation films. The second insulation films are formed to a thickness twice as thick as the arsenic ion implantation depth, and the minimum thickness is 100nm. On the other hand, thicker second insulation films are better for preventing arsenic ion penetration, though the film thickness tends to deviate from its reference value as the second insulation film thickness increases. However, the maximum thickness suitable for mass production is about 500nm. Therefore, a preferable thickness of the second insulation films is from 100 to 350nm. It is more preferable to confine the second insulation films to a range of thicknesses between 200 and 350nm. In any event, it is important to control the thickness of the second insulation films more accurately than is the case in the prior art methods. The second insulation films may be formed prior to the STEP(4). However, it is preferable to form the second insulation films after STEP(4) is completed, since then any lattice defects caused in the silicon surface layer by boron ion implantation are annealed out during STEP(4).

The heavily doped n-type regions can be selectively formed by the steps (5), (6) and (9), avoiding the step of patterning the photoresist film by photolithography (the STEP(9) of the prior art) that has been hitherto indispensable in the prior art. Thus, one step is eliminated from the conventional photo-processing steps of the prior art methods.

By utilising the monitoring area in the steps (6) and (11), the contact holes which reach the p-type regions 5, the contact holes which reach the heavily doped regions 9,and, if necessary, the contact holes which reach the p-type regions 5 and the heavily doped regions 9 can be simultaneously formed as by the prior art. The number of steps for forming these contact holes is the same as that of the prior art.

Thus, one step is reduced in total from the prior art method. Figure 7 is a cross section of the major part of the semiconductor device manufactured by the method described above. A p-channel MOS is shown on the left hand side of the figure, and an n-channel MOS on the right hand side of the figure. A back gate electrode 12(PB), a source electrode 12(PS), and a drain electrode 12(PD) in the p-channel MOS; and a back gate electrode 12(NB), a source electrode 12(NS), a drain electrode 12(ND), and a gate electrode 8(NG) in the n-channel MOS are formed on the major surface of the semiconductor wafer 200 to form a semiconductor device 1.

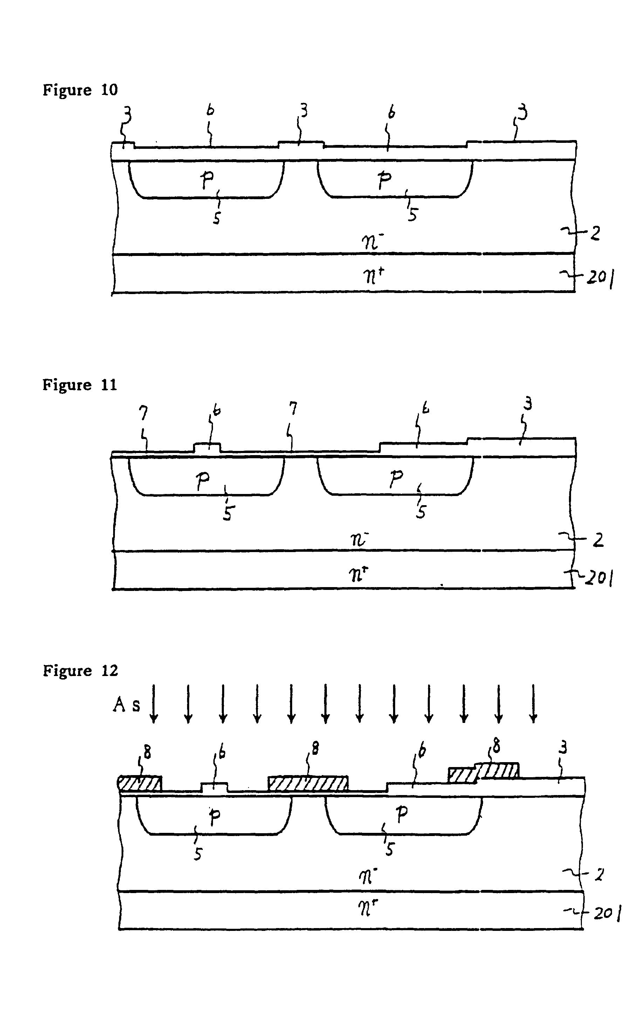

Figures 8 to 14 show a second embodiment of a manufacturing method of the present invention. This second method is an example that applies the present invention to a vertical MOSFET. Explanation will be made only in relation to the differences between the second and first embodiments.

Referring now to Figure 8 showing the STEP(1) of the second embodiment, the semiconductor wafer consists of an n-type drain region 201 doped with antimony at 10¹⁸ to 10¹⁹cm⁻³ and an n-type semiconductor layer 2, doped with phosphorus at 10¹³ to 10¹⁶cm⁻³, epitaxially grown to a thickness of around 100nm on the drain region 201.

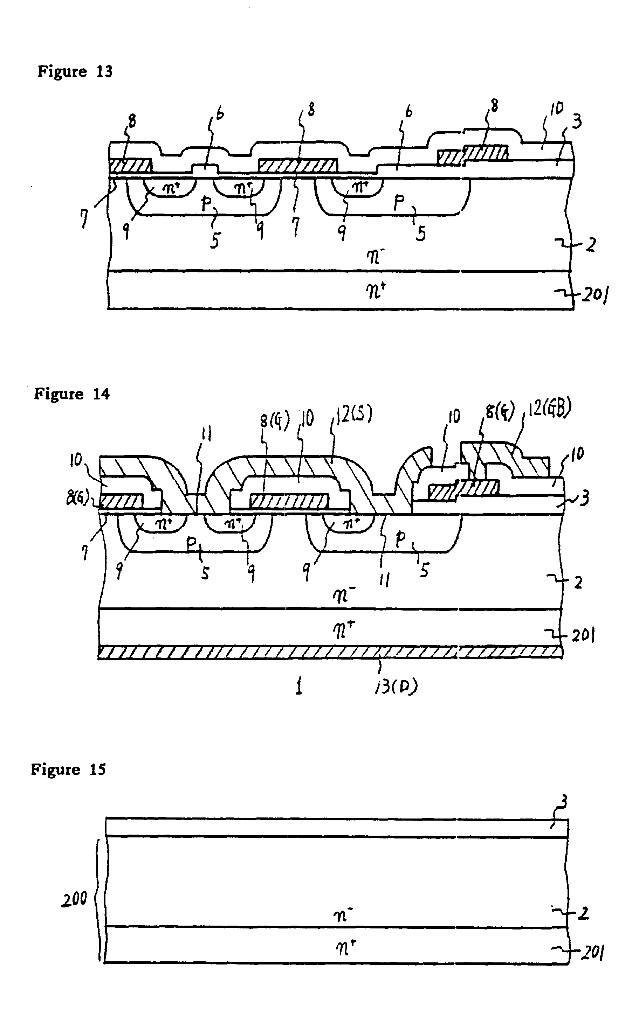

Figure 14 is a cross section of a major portion of the semiconductor device manufactured by the second manufacturing method of the invention.

Referring now to Figure 14 showing the STEP(12) of the second embodiment, the thickness of the metal electrode 12 is from 3 to 5*µ*m.

A STEP(13) is added subsequently to the STEP(12).

STEP(13): A Ti-Ni-Au triple-layered back electrode 13 is formed on the back surface of the semiconductor wafer 200 by vacuum deposition. The other steps (2) to (11) are the same as those of the first embodiment. Parts in Figures 8 to 13 are designated by the same reference numerals as their counterparts in Figures 1 to 6. In Figure 14, a source electrode 12(S), gate electrode 8(G) and gate wiring 12(GB) are formed on a major surface of the semiconductor wafer 200 and a drain electrode 13(D) on another major surface of the semiconductor wafer 200 to form the semiconductor device 1.

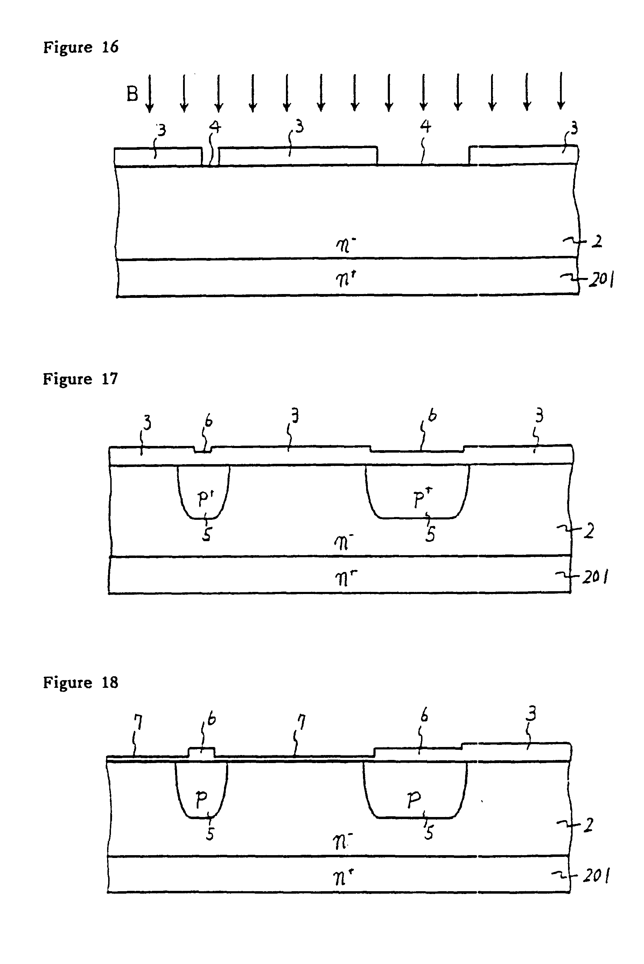

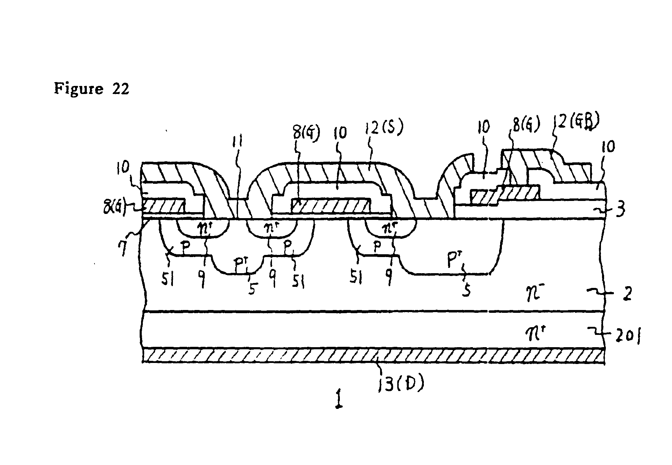

Figures 15 to 22 show a third manufacturing method of the present invention. The third embodiment is an example that applies the present invention to a double diffusion type vertical MOSFET in that the p-type regions 5 are relatively heavily doped and formed relatively deep for improving the avalanche withstand capability. Explanation will be made only in relation to the differences between the third and second embodiments.

The boron dose in the STEP(3) is large 1x10¹⁴ to 1x10¹⁵cm⁻².

A following STEP(8.1) is inserted between the steps (8) and (9).

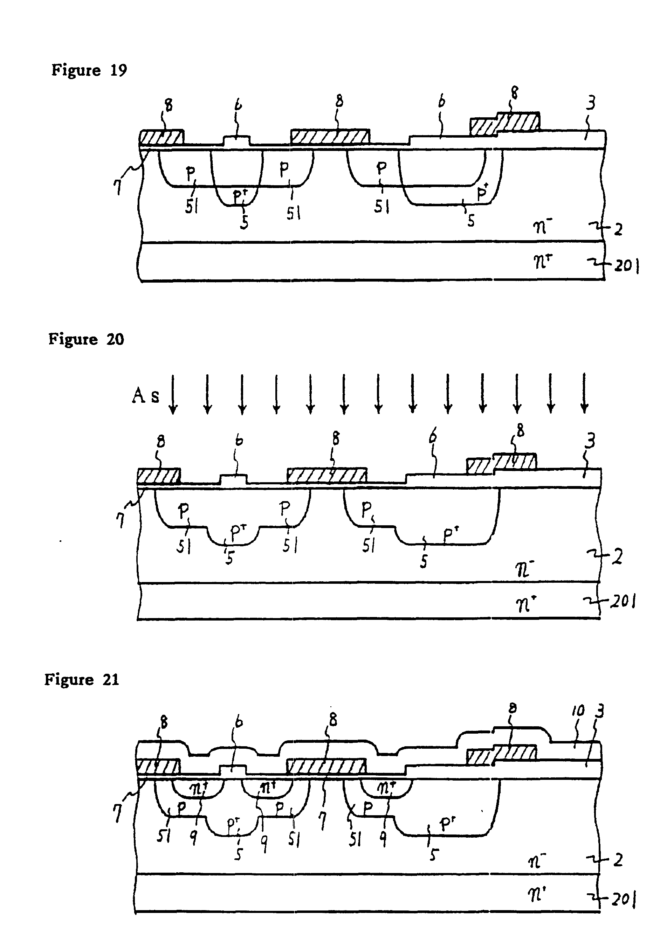

STEP(8.1): Referring now to Figure 19, second p-type regions 51 are formed, for example, by implanting boron ions at 50keV and at a dosage of from 10¹³ to 10¹⁴cm⁻² and by subsequent heat treatment at 1100 to 1150°C for 5 hours. The other steps (1) to (13) are the same as those of the second embodiment, with the exception of the additional step. Parts in Figures 15 to 22 are designated by the same reference numerals as their corresponding parts in Figures 8 to 14.

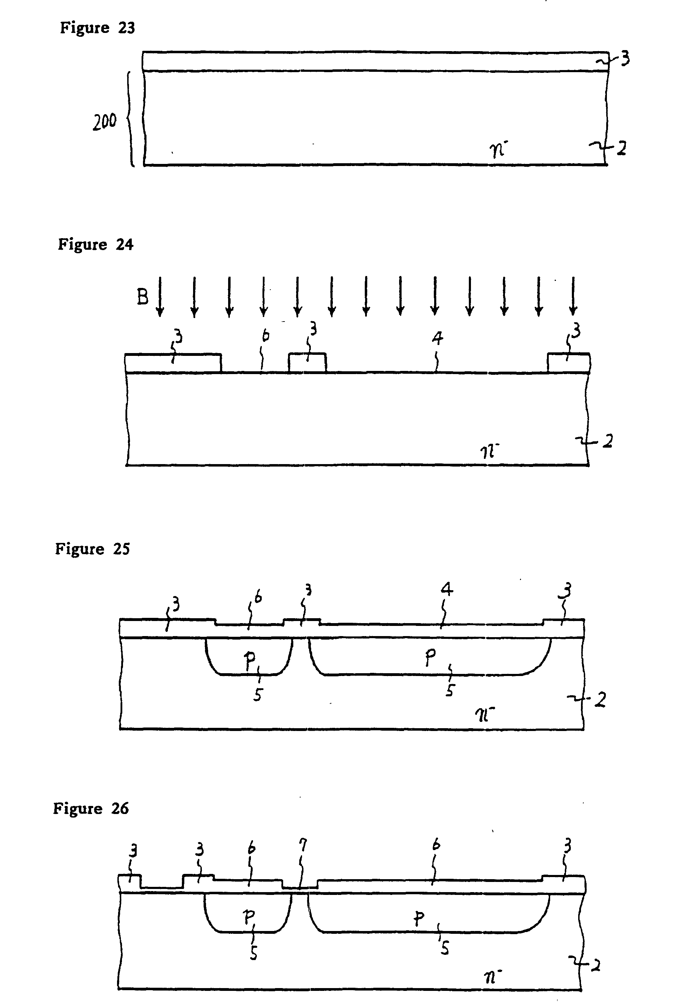

Figures 23 to 30 show a fourth manufacturing method of the present invention. The fourth embodiment is an example that applies the present invention to a lateral MOSFET. Explanation will be made only in relation to the differences between the fourth and first embodiments.

The following STEP(8.1) is added between the steps (8) and (9).

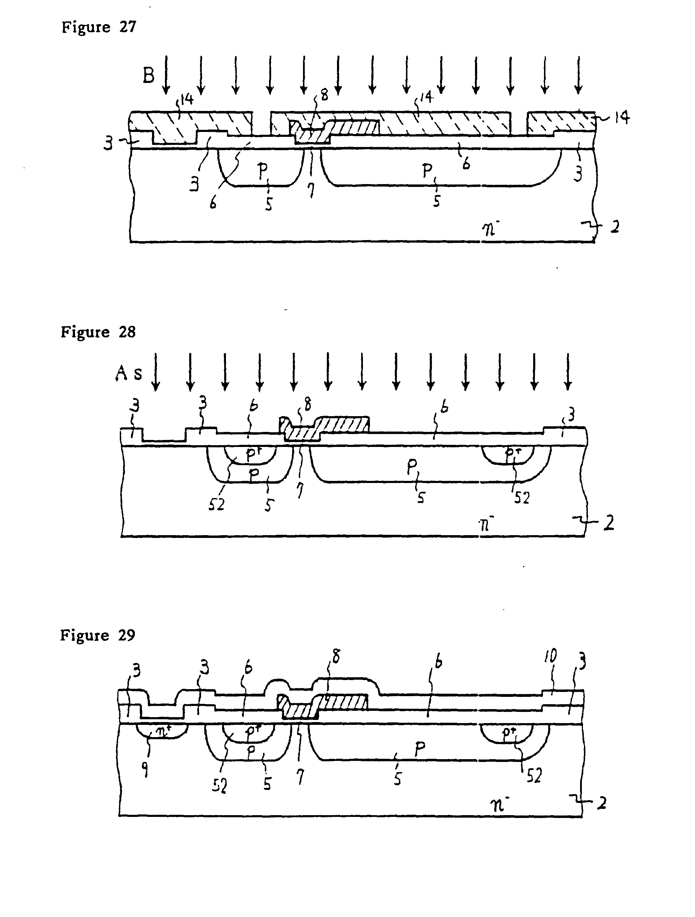

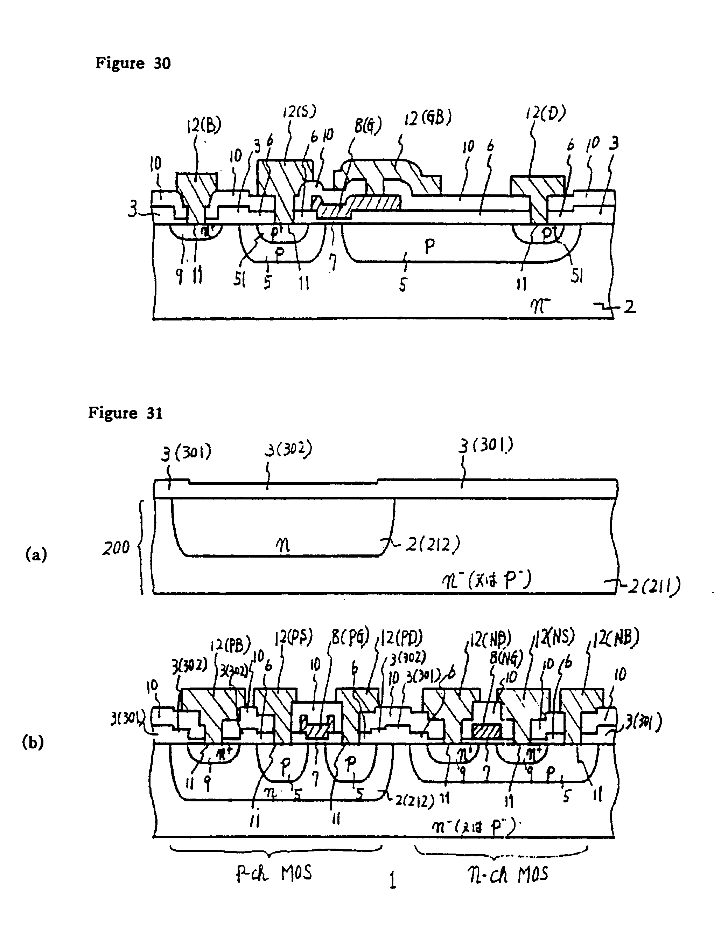

STEP(8.1): Referring now to Figure 27, a heavily doped p-type regions 52 are formed to improve the contact between the metal electrode 12 and the p-type regions, for example, by implanting boron ions at 150keV at a dosage of 10¹⁴ to 5x10¹⁵cm⁻², using a photoresist film 14 patterned by photolithography for masking, and activating the implanted boron ions by heat treatment at 1000°C for 10 minutes. The other steps (1) to (12) except this additional step are the same as those of the first embodiment. Parts in Figures 23 to 29 are designated by the same reference numerals as their counterparts in Figures 1 to 6. Figure 30 is a cross section of a major portion of the semiconductor device manufactured by the fourth manufacturing method of the invention. In Figure 30, a back gate electrode 12(B), source electrode 12(S), drain electrode 12(D) and gate wiring 12(GB) are formed on a major surfaces of the semiconductor wafer 200 to form the semiconductor device 1.

The method of forming the heavily doped p-type regions 52 by the processing STEP(8.1) is applicable to all the embodiments which will be explained below as well as to all the embodiments already explained.

Figures 31(a) and 31(b) show a fifth method of the present invention. The fifth embodiment, that is a modification of the first embodiment, will be explained only in relation to the differences from the first embodiment.

Referring now to Figure 31(a), the n-type semiconductor layer 2 of the semiconductor wafer 200 is composed of a lightly doped region 2(211) having a dopant concentration of from 10¹³ to 10¹⁶cm⁻³ and a heavily doped region 2(212) doped at the dosage amount of around 10¹³cm⁻². By adding processing steps for forming the n-type semiconductor layer 2 as described above, the first insulation film 3 is composed of a relatively thick portion 3(301) and a relatively thin portion 3(302). The alternative steps of the STEP(1) will be explained below.

STEP(1.1): A silicon oxide film is grown to a thickness of 500nm by oxidising the semiconductor wafer 200 comprising the lightly doped n-type semiconductor layer 2(211) in steam at 1100°C for 45 minutes, to form an insulation film 3(301), i.e. the thick portion of the first insulation film 3.

STEP(1.2): The insulation film 3(301) is selectively removed with hydrofluoric acid by using a photoresist film patterned by photolithography as a mask.

STEP(1.3): Phosphorus ions are implanted at the dose of around 1x10¹³cm⁻² at 100keV.

STEP(1.4):Then, a heavily doped n-type region 2(212) is formed by thermal drive at 1150°C for 200 minutes.

STEP(1.5): Finally, a silicon oxide film is grown to a thickness of about 1000nm by steam oxidation at 1100°C for about 3 hours, to form the thick portion 3(301) and the thin portion 3(302).

These steps (1.1) to (1.5) substitute for the STEP(1) of the first embodiment. When the STEP(1.5) is over, the thick portion 3(301) and the thin portion 3(302) are 1100nm and 1000nm in thickness, respectively. The other steps (2) to (12) are the same as those of the first embodiment.

Parts in Figures 31(a) and 31(b) are designated by the same reference numerals as their corresponding parts in Figures 1 and 7.

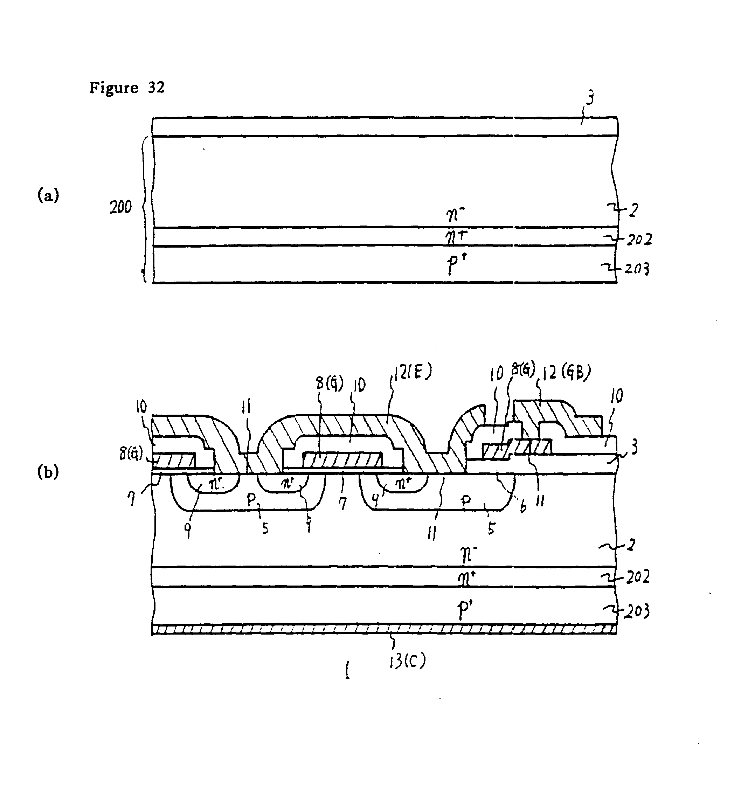

Figures 32(a) and 32(b) show a sixth manufacturing method of the present invention. Since the sixth embodiment is almost the same as the second embodiment except for a slight difference, explanation will be confined to this difference.

Referring now to Figure 32(a), a semiconductor wafer 200 is comprised of a p-type collector region 203 having a boron dopant concentration of around 10¹⁹cm⁻³; a heavily doped n-type buffer region 202 of 10 to 20*µ*m in thickness grown on the collector region 203 and having a phosphorus dopant concentration in the order 10¹⁷cm⁻³; and a lightly doped n-type semiconductor layer 2 grown on the buffer layer 202. The other STEPS(2) to (13) are the same as those of the second embodiment. Parts in Figures 32(a) and 32(b) are designated by the same reference numerals as their corresponding parts in Figures 8 and 14. Figure 32(b) is a cross section of a major portion of the semiconductor device manufactured by the sixth method of the invention. In Figure 32(b), an emitter electrode 12(E), gate electrode 8(G) and gate wiring 12(GB) are formed on one major surface of the semiconductor wafer 200, and a collector electrode 13(C) is formed on the collector region 203, i.e. on the other major surface of the semiconductor wafer 200, to form the semiconductor device 1.

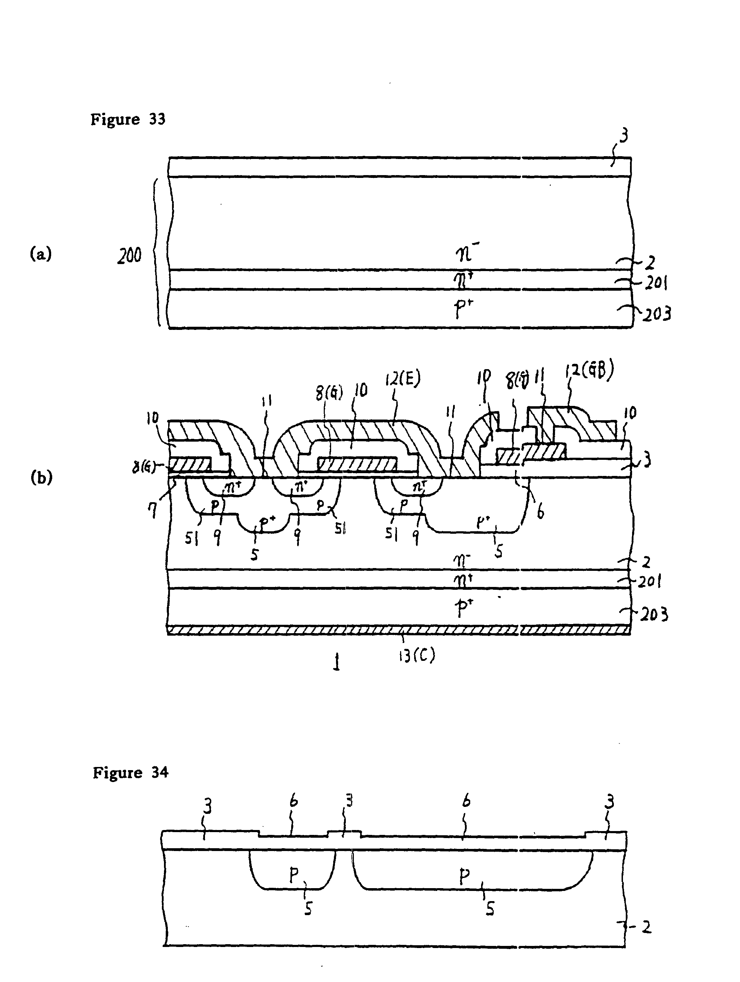

Figures 33(a) and 33(b) show a seventh method of the present invention. The seventh embodiment is an example that applies the present invention to a double diffusion type vertical IGBT. Referring now to Figure 33(a), the seventh embodiment is almost the same as the third embodiment except that the semiconductor wafer 200 of the third embodiment is replaced by the semiconductor wafer 200 of the sixth embodiment. The other steps (2) to (13) are the same as those of the third embodiment. Parts in Figures 33(a) and 33(b) are designated by the same reference numerals as their corresponding parts in Figures 32(a) and 32(b).

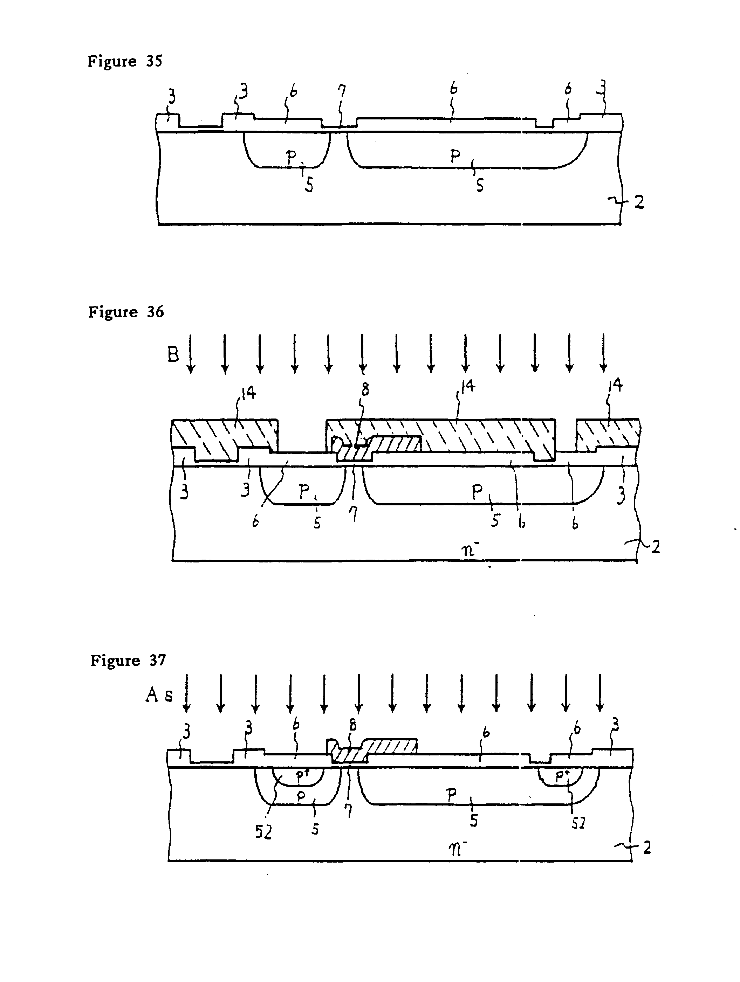

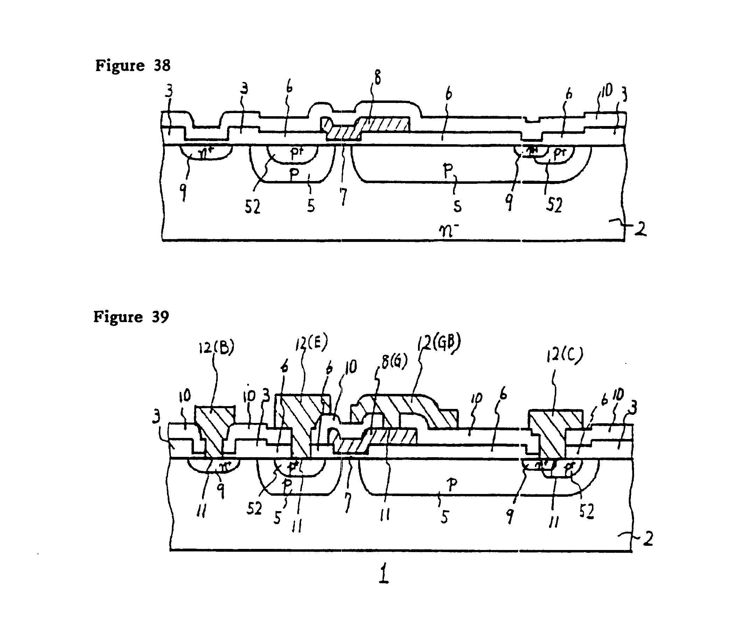

Figures 34 to 39 show an eighth manufacturing method of the present invention. The eighth embodiment is an example that applies the present invention to a lateral IGBT. Here, the drawings corresponding to Figures 1 to 3 of the first embodiment, for example, are omitted. The processing steps except STEP(9) of the eighth embodiment are almost the same as those of the fourth embodiment. Referring to Figure 37 that shows the STEP(9) of the eighth embodiment, a heavily doped n-type region 9 is formed in the heavily doped p-type regions 52 that constitute a drain region. STEPS(1) to (8) and the STEPS(10) to (12) are the same as those of the fourth embodiment. Parts in Figures 34 to 39 are designated by the same reference numerals as their corresponding parts in Figures 25 to 30.

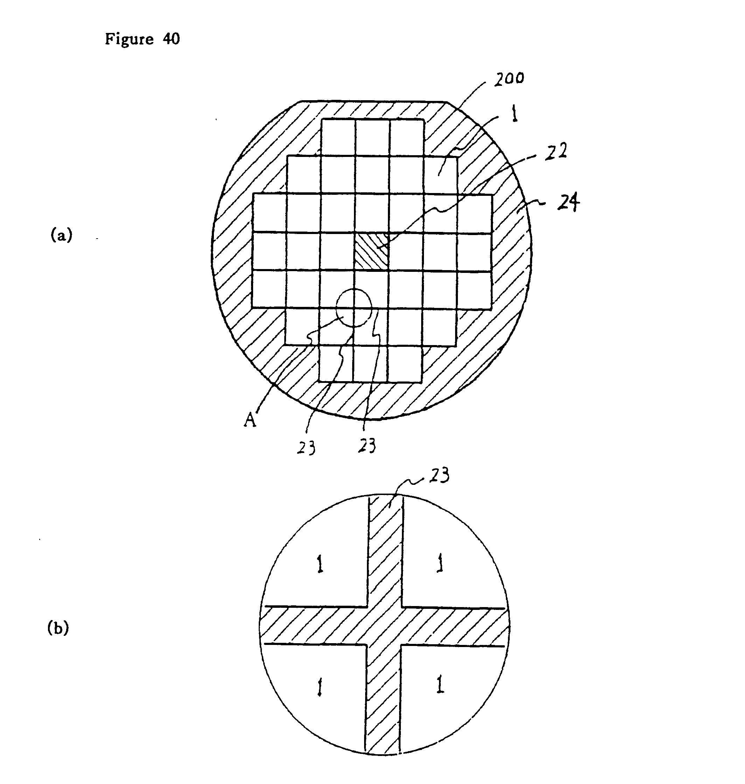

Figures 40(a) and 40(b) show a ninth embodiment of the invention. Specifically, Figures 40(a) and 40(b) show a location in which a monitor region 22, used in STEP(11) of the first embodiment for determining the end of the etching of the contact holes, is provided. Figure 40(a) shows a monitor region 22 surrounded by four semiconductor devices 1 arranged on the semiconductor wafer 200 and a peripheral region 24 of the wafer 200 on which the semiconductor devices 1 are not arranged. Figure 40(b) is an enlarged view of the area of Figure 40(a) within circle A, clearly showing scribe lines 23. A single monitor region 22 may be used or a plurality of monitor regions 22 may be located on any combined locations of the surrounded region, peripheral region and scribe line.

Figure 41 is a cross section of the monitor region of Figure 40. At the time of etching, the monitor region has a second insulation film 6 and a fourth insulation film 10 laminated on the p-type region 5 formed on the n-type semiconductor layer 2. A photoresist film 25 formed on the fourth insulation film 10 as an etching mask has an opening 251 on the region.

Although the present invention has been described in connection with preferred embodiments thereof, many variations will now become apparent to those skilled in the art. For example, by reversing the respective conductivity types of each semiconductor regions, the present invention is applicable to n-channel devices and p-channel devices. Modifications of the invention will also become apparent to those skilled in the art. For example, a fifth insulation film may be formed by removing the third insulation film except at those regions beneath the gate electrodes 8 by etching with hydrofluoric acid using the gate electrodes 8 as a mask, and by subsequently oxidising that portion from which the third insulation film has been removed.

It is also apparent that the possible modifications include addition of various semiconductor regions, insulation films, conductive films and protective films which have not been described in the above described embodiments. And, it is apparent that the second insulation film may be formed prior to, after or simultaneously with the formation of the p-type region.

By combining any one of the first and fifth embodiments with any one of the second, third, fourth, sixth, seventh and eighth embodiments or by combining the embodiments of the invention with other processing steps known to those skilled in the part, a power IC can be constructed.

By applying the present invention to the process of manufacture of ICs, vertical MOSFETs, vertical IGBTs, lateral MOSFETs or lateral IGBTs, a sheet of photo-mask (one photo-processing step) is eliminated from the manufacturing process to lower the cost of the semiconductor devices, while the same performance is achieved as that of the respective prior art production methods.

## Claims

1. A method of manufacturing at least one semiconductor device on a single or multi-layered semiconductor substrate, the method comprising the steps of:
forming a first insulation film (3) on a major surface of a layer (2) of a first conductivity type of said semiconductor substrate;
selectively removing a part of said first insulation film, thereby to form at least one window (4) in the first insulation film (3);
implanting impurity ions of a second conductivity type into said layer (2) of the first conductivity type through said at least one window (4);
selectively forming at least one region (5) of a second conductivity type by thermally diffusing said implanted impurity ions into said layer (2) of the first conductivity type;
forming a second insulation film (6) prior to or after the formation of said at least one region (5) of the second conductivity type;
selectively removing a part of said first (3) and second (6) insulation films thereby to expose a part of said layer (2) of the first conductivity type and a part of said at least one region(s) of the second conductivity type;
forming third insulation films (7) on said exposed part of said layer (2) of the first conductivity type and said exposed part of said at least one region (5) of the second conductivity type;
forming gate electrodes (8) on said third insulation films (7);
forming heavily doped regions (9) of the first conductivity type by selectively implanting impurity ions of the first conductivity type, using said first insulation film (3), said second insulation film (6), and said gate electrodes (8) for masking, into the portions of said layer (2) of the first conductivity type and said at least one region (5) of the second conductivity type, said portions being not covered with said first insulation film (3) said second insulation film (6) and said gate electrodes (8);
forming a fourth insulation film (10) atop said at least one semiconductor device; and
simultaneously forming at least one contact hole (11) that reaches said at least one region (5) of the second conductivity type through said fourth (10) and second (6) insulation films and at least one contact hole (11) that reaches said heavily doped regions of the first conductivity type through said fourth insulation film (10), **characterised in that** said second insulation film (6) is more than twice as thick as the average implantation depth of said impurity ions of the first conductivity type in the insulation film.

2. A method claimed in claim 1, **characterised in that** said second insulation film (6) is less than ten times as thick as the average implantation depth of said impurity ions of the first conductivity type in the insulation film.

3. A method claimed in claim 1, **characterised in that** a plurality of the semiconductor devices are arranged on said semiconductor substrate, and wherein at least one monitor region (22) for judging the end of etching process for removing said fourth (10) and second (6) insulation films at the formation of said contact holes (11), is formed on at least one of the regions (5) of the second conductivity type on a portion of said semiconductor substrate (2) wherein said plurality of the semiconductor devices is not arranged, said at least one monitor region (22) comprising a second insulation film (6) and a fourth insulation film (10) laminated on said at least one region (5) of the second conductivity type, said etching process being terminated after said second (6) and fourth (10) insulation films have been removed and said region has been exposed.

4. A method claimed in claim 3 **characterised in that** said at least one monitor region (22) is arranged outside that region of said semiconductor substrate wherein said plurality of the semiconductor devices are arranged.

5. A method as claimed in claim 4, wherein said at least one monitor region (22) is surrounded by a plurality of the semiconductor devices.

6. A method as claimed in claim 4, wherein said at least one monitor region (22) is arranged on a scribe line (23) disposed for separating two of said plurality of the semiconductor devices.

7. A method as claimed in claim 4, **characterised in that** said at least one monitor region (22) is arranged in the peripheral region of said semiconductor substrate (2) wherein said plurality of the semiconductor devices are not arranged.

8. A method as claimed in claim 1 **characterised in that** said contact holes (11) are formed by etching said fourth (10) and second (6) insulation films, and said etching is terminated after a predetermined period of time has elapsed, said predetermined period consisting of a leeway period and an estimated period, said estimated period being a determined or calculated period of time during that said fourth (10) and second (6) insulation films are completely removed.

9. A method as claimed in any one of preceding claims 1 to 8 characterised by forming the thickness of the insulation films (5), (6), (10) so that they vary around each of the contact holes (11) between the contact holes (11) or around and between the contact holes (11).

10. The method as claimed in claim 9, **characterised in that** at least one of the devices is selected from a group consisting of an insulated gate type device, an IC and power IC.

11. The method as claimed in claim 9, **characterised in that** at least one of the devices selected from a group consisting of a vertical MOSFET, and vertical IGBT, a lateral MOSFET and a lateral IGBT.

## Patentansprüche

1. Verfahren zur Herstellung mindestens eines Halbleiterbauelements auf einem ein- oder mehrlagigen Halbleitersubstrat, wobei das Verfahren die folgenden Schritte umfaßt:
Ausbilden einer ersten Isolationsschicht (3) auf einer Hauptoberfläche einer Schicht (2) eines ersten Leitfähigkeitstyps des Halbleitersubstrats;
selektives Entfernen eines Teils der ersten Isolationsschicht, um dadurch mindestens ein Kontaktfenster (4) in der ersten Isolationsschicht (3) auszubilden;
Implantieren von Fremdionen eines zweiten Leitfähigkeitstyps in die Schicht (2) des ersten Leitfähigkeitstyps durch das mindestens eine Kontaktfenster (4) hindurch;
selektives Ausbilden von mindestens einem Bereich (5) eines zweiten Leitfähigkeitstyps durch thermisches Diffundieren der implantierten Fremdionen in die Schicht (2) des ersten Leitfähigkeitstyps;
Ausbilden einer zweiten Isolationsschicht (6) vor oder nach der Ausbildung des mindestens einen Bereichs (5) des zweiten Leitfähigkeitstyps;
selektives Entfernen eines Teils der ersten (3) und der zweiten (6) Isolationsschicht, um dadurch einen Teil der Schicht (2) des ersten Leitfähigkeitstyps und einen Teil des mindestens einen Bereichs (5) des zweiten Leitfähigkeitstyps freizulegen;
Ausbilden von dritten Isolationsschichten (7) auf dem freiliegenden Teil der Schicht (2) des ersten Leitfähigkeitstyps und dem freiliegenden Teil des mindestens einen Bereichs (5) des zweiten Leitfähigkeitstyps;
Ausbilden von Gateelektroden (8) auf den dritten Isolationsschichten (7);
Ausbilden von stark dotierten Bereichen (9) des ersten Leitfähigkeitstyps durch selektives Implantieren von Fremdionen des ersten Leitfähigkeitstyps unter Verwendung der ersten Isolationsschicht (2), der zweiten Isolationsschicht (6) und der Gateelektroden (8) zum Maskieren, in den Teilen der Schicht (2) des ersten Leitfähigkeitstyps und dem mindestens einen Bereich (5) des zweiten Leitfähigkeitstyps, wobei die Teile nicht mit der ersten Isolationsschicht (3), der zweiten Isolationsschicht (6) und den Gateelektroden (8) bedeckt sind;
Ausbilden einer vierten Isolationsschicht (10) auf dem mindestens einen Halbleiterbauelement; und
gleichzeitiges Ausbilden von mindestens einem Kontaktloch (11), das den mindestens einen Bereich (5) des zweiten Leitfähigkeitstyps durch die vierte (10) und die zweite (6) Isolationsschicht hindurch erreicht, und von mindestens einem Kontaktloch (11), das die stark dotierten Bereiche des ersten Leitfähigkeitstyps durch die vierte Isolationsschicht (10) hindurch erreicht, **dadurch gekennzeichnet**, daß die zweite Isolationsschicht (6) mehr als zweimal so dick ist wie die mittlere Implantationstiefe der Fremdionen des ersten Leitfähigkeitstyps in der Isolationsschicht.

2. Verfahren nach Anspruch 1, **dadurch gekennzeichnet**, daß die zweite Isolationsschicht (6) geringer ist als zehnmal so dick wie die mittlere Implantationstiefe der Fremdionen des ersten Leitfähigkeitstyps in der Isolationsschicht.

3. Verfahren nach Anspruch 1, **dadurch gekennzeichnet**, daß eine Vielzahl der Halbleiterbauelemente auf dem Halbleitersubstrat angeordnet werden, und wobei mindestens ein Kontrollbereich (22) zum Beurteilen des Endes des Ätzprozesses zum Entfernen der vierten (10) und der zweiten (6) Isolationsschicht bei der Ausbildung der Kontaktlöcher (11) auf mindestens einem der Bereiche (5) des zweiten Leitfähigkeitstyps auf einem Teil des Halbleitersubstrats (2), auf dem die Vielzahl der Halbleiterbauelemente nicht angeordnet sind, ausgebildet wird, wobei der mindestens eine Kontrollbereich (22) eine zweite Isolationsschicht (6) und eine vierte Isolationsschicht (10) umfaßt, die auf den mindestens einen Bereich (5) des zweiten Leitfähigkeitstyps laminiert sind, wobei der Ätzprozeß beendet wird, nachdem die zweite (6) und die vierte (10) Isolationsschicht entfernt wurden und der Bereich freigelegt wurde.

4. Verfahren nach Anspruch 3, **dadurch gekennzeichnet**, daß der mindestens eine Kontrollbereich (22) außerhalb jenes Bereichs des Halbleitersubstrats angeordnet wird, in dem die Vielzahl der Halbleiterbauelemente angeordnet sind.

5. Verfahren nach Anspruch 4, wobei der mindestens eine Kontrollbereich (22) von einer Vielzahl der Halbleiterbauelemente umgeben ist.

6. Verfahren nach Anspruch 4, wobei der mindestens eine Kontrollbereich (22) auf einem Ritzgraben (23) angeordnet wird, der zum Trennen von zwei der Vielzahl der Halbleiterbauelemente angeordnet ist.

7. Verfahren nach Anspruch 4, **dadurch gekennzeichnet**, daß der mindestens eine Kontrollbereich (22) im Randbereich des Halbleitersubstrats (2), in dem die Vielzahl der Halbleiterbauelemente nicht angeordnet sind, angeordnet wird.

8. Verfahren nach Anspruch 1, **dadurch gekennzeichnet**, daß die Kontaktlöcher (11) durch Ätzen der vierten (10) und der zweiten (6) Isolationsschicht ausgebildet werden und das Ätzen beendet wird, nachdem ein vorbestimmter Zeitraum vergangen ist, wobei der vorbestimmte Zeitraum aus einem Spielraumzeitraum und einem abgeschätzten Zeitraum besteht, wobei der abgeschätzte Zeitraum ein ermittelter oder berechneter Zeitraum ist, während dem die vierte (10) und die zweite (6) Isolationsschicht vollständig entfernt werden.

9. Verfahren nach einem der vorangehenden Ansprüche 1 bis 8, gekennzeichnet durch Ausbilden der Dicke der Isolationsschichten (5), (6), (10) so, daß sie um jedes der Kontaktlöcher (11), zwischen den Kontaktlöchern (11) oder um und zwischen den Kontaktlöchern (11) variiert.

10. Verfahren nach Anspruch 9, **dadurch gekennzeichnet**, daß zumindest eines der Bauelemente aus einer Gruppe ausgewählt ist, die aus einem Bauelement mit isoliertem Gate, einer IC und einer Leistungs-IC besteht.

11. Verfahren nach Anspruch 9, **dadurch gekennzeichnet**, daß zumindest eines der Bauelemente aus einer Gruppe ausgewählt ist, die aus einem vertikalen MOSFET und einem vertikalen IGBT, einem lateralen MOSFET und einem lateralen IGBT besteht.

## Revendications

1. Procédé pour fabriquer au moins un dispositif à semi-conducteurs sur un substrat semi-conducteur unique ou multicouche, le procédé comportant les étapes consistant à :
former un premier film isolant (3) sur une surface principale d'une couche (2) d'un premier type de conductivité dudit substrat semi-conducteur,
éliminer de manière sélective une partie dudit premier film isolant, de manière à former au moins une fenêtre (4) dans le premier film isolant (3),
implanter des ions d'impureté d'un second type de conductivité dans ladite couche (2) du premier type de conductivité à travers ladite au moins une fenêtre (4),
former de manière sélective au moins une région (5) d'un second type de conductivité par diffusion thermique desdits ions d'impureté implantés dans ladite couche (2) du premier type de conductivité,
former un deuxième film isolant (6) avant ou après la formation de ladite au moins une région (5) du second type de conductivité,
éliminer de manière sélective une partie desdits premier (3) et deuxième (6) films isolants de manière à exposer une partie de ladite couche (2) du premier type de conductivité et une partie de ladite au moins une région (5) du second type de conductivité,
former des troisièmes films isolants (7) sur ladite partie exposée de ladite couche (2) du premier type de conductivité et sur ladite partie exposée de ladite au moins une région (5) du second type de conductivité,
former des électrodes de grille (8) sur lesdits troisièmes films isolants (7),
former des régions fortement dopées (9) du premier type de conductivité en implantant de manière sélective des ions d'impureté du premier type de conductivité, en utilisant ledit premier film isolant (3), ledit deuxième film isolant (6) et lesdites électrodes de grille (8) pour un masquage, dans les parties de ladite couche (2) du premier type de conductivité et ladite au moins une région (5) du second type de conductivité, lesdites parties n'étant pas recouvertes par ledit premier film isolant (3), ledit deuxième film isolant (6) et lesdites électrodes de grille (8),
former un quatrième film isolant (10) au-dessus dudit au moins un dispositif à semi-conducteurs, et
former simultanément au moins un trou de contact (11) qui atteint ladite au moins une région (5) du second type de conductivité à travers lesdits quatrième (10) et deuxième (6) films isolants, et au moins un trou de contact (11) qui atteint lesdites régions fortement dopées du premier type de conductivité à travers ledit quatrième film isolant (10),
**caractérisé en ce que** ledit deuxième film isolant (6) est deux fois plus épais que la profondeur d'implantation moyenne desdits ions d'impureté du premier type de conductivité dans le film isolant.

2. Procédé selon la revendication 1, **caractérisé en ce que** ledit deuxième film isolant (6) est inférieur à dix fois l'épaisseur de la profondeur d'implantation moyenne desdits ions d'impureté du premier type de conductivité dans le film isolant.

3. Procédé selon la revendication 1, **caractérisé en ce qu**'une pluralité de dispositifs à semi-conducteurs sont agencés sur ledit substrat semi-conducteur, et dans lequel au moins une région de surveillance (22), destinée à évaluer la fin du processus de gravure pour éliminer lesdits quatrième (10) et deuxième (6) films isolants au niveau de la formation desdits trous de contact (11), est formée sur au moins une des régions (5) du second type de conductivité sur une partie dudit substrat semi-conducteur (2) dans laquelle ladite pluralité de dispositifs à semi-conducteurs n'est pas agencée, ladite au moins une région de surveillance (22) comportant un deuxième film isolant (6) et un quatrième film isolant (10) stratifiés sur ladite au moins une région (5) du second type de conductivité, ledit processus de gravure étant terminé après avoir éliminé lesdits deuxième (6) et quatrième (10) films isolants et après avoir exposé ladite région.

4. Procédé selon la revendication 3, **caractérisé en ce que** ladite au moins une région de surveillance (22) est agencée à l'extérieur de la région dudit substrat semi-conducteur dans laquelle ladite pluralité des dispositifs à semi-conducteurs sont agencés.

5. Procédé selon la revendication 4, dans lequel ladite au moins une région de surveillance (22) est entourée d'une pluralité de dispositifs à semi-conducteurs.

6. Procédé selon la revendication 4, dans lequel ladite au moins une région de surveillance (22) est agencée sur une ligne de tranchée (23) disposée pour séparer deux dispositifs parmi ladite pluralité des dispositifs à semi-conducteurs.

7. Procédé selon la revendication 4, **caractérisé en ce que** ladite au moins une région de surveillance (22) est agencée dans la région périphérique dudit substrat semi-conducteur (2) dans laquelle ladite pluralité des dispositifs à semi-conducteurs ne sont pas agencés.

8. Procédé selon la revendication 1, **caractérisé en ce que** lesdits trous de contact (11) sont formés par gravure desdits quatrième (10) et deuxième (6) films isolants, et ladite gravure est terminée après qu'une période prédéterminée de temps se soit écoulée, ladite période prédéterminée étant constituée d'une période de dérive et une période estimée, ladite période estimée étant une période de temps déterminée ou calculée pendant laquelle lesdits quatrième (10) et deuxième (6) films isolants sont complètement éliminés.

9. Procédé selon l'une quelconque des revendications 1 à 8, caractérisé par la formation de l'épaisseur des films isolants (5), (6), (10), de sorte qu'ils varient autour de chacun des trous de contact (11) entre les trous de contact (11) ou autour et entre les trous de contact (11).

10. Procédé selon la revendication 9, **caractérisé en ce qu**'au moins un des dispositifs est sélectionné parmi un groupe constitué d'un dispositif de type grille isolée, d'un circuit intégré (IC) et d'un IC de puissance.

11. Procédé selon la revendication 9, **caractérisé en ce qu'**au moins un des dispositifs est sélectionné parmi un groupe constitué d'un transistor MOSFET vertical, d'un transistor IGBT vertical, d'un transistor MOSFET latéral et d'un transistor IGBT latéral.
